# EUROPEAN PATENT SPECIFICATION

(11) **EP 1 659 567 B1**
(45) Date of publication and mention of the grant of the patent: **18.06.2014**
(21) Application number: 05110825.6
(22) Date of filing: 16.11.2005
(51) Int. Cl.: G09G 5/24

(54) **Font data management**
Verwaltung von Schriftartdaten
Gestion de données de polices

(30) Priority: 19.11.2004 GB 0425433
(43) Date of publication of application: 24.05.2006
(73) Proprietor: Vestel Elektronik Sanayi ve Ticaret A.S., 45030 Manisa (TR)
(72) Inventor: Hemingway, Peter, Bristol, Avon BS16 6DJ (GB)
(74) Representative: Beck Greener

(56) References cited:
- US-A- 4 590 585
- US-A- 5 221 921
- US-A- 5 771 034

## Description

The present invention relates to font data management and particularly to a font data storage device and a method of structuring font data for storage in a memory. The present invention is concerned with font data management that is particularly, but not exclusively, suited for use with lower resolution displays such as emissive displays.

Lower resolution displays are employed in set-top boxes and other consumer electronic devices having limited power and / or limited processing and memory resources including but not restricted to mobile phones, PDA's and MP3 players. In general, images of numbers and letters to be displayed on such lower resolution displays are stored as bitmaps, or antialiased pixmaps, with each pixmap comprising a glyph foreground in combination with background space in and surrounding the glyph. Conventionally, for a particular font all of the alphanumeric characters and associated punctuation are stored individually in the same fixed width size antialiased pixmaps. The size of the pixmap must, therefore, be sufficient to accommodate the glyph with the highest ascender, the glyph with the lowest descender and the glyph with the widest character. This results in only part of the area of any one of the pixmaps being covered by the glyph foreground. This in turn means that for electronic components having limited resources, critical resources such as memory space and processing power are being used to store and render uninformative background pixels in each pixmap.

A known alternative for storing alphanumeric characters is outline fonts. However, the number of instructions required to represent individual characters is such that outline fonts generally require much more memory than pixmaps, especially for non-western typefaces. Also, before a numeral or letter stored as outline font data can be displayed, the outline font data must first be rasterised. This means that outline fonts also demand far greater processing resources than that of pixmap fonts. Consequently, outline fonts are not suitable for use with electronic devices having limited processing and/or memory resources.

In US 4,481,602 a method of font compression is described in which the height of individual characters stored in the font memory varies between characters. This enables some reduction in the size of the font memory but for the method to work the width of each character is fixed to a maximum width for the set of characters.

A font format for displaying text-based characters which includes a simplified header is described in US 5,771,034. The header information for each of the glyphs includes information on the Byte width and the Byte height of the glyph.

It is therefore an object of the present invention to provide an improved font data management which uses less memory for storing fonts in comparison to existing font data formats.

Accordingly, in a first aspect, the present invention provides a font data storage device in accordance with claim 1. The font data storage device comprises a memory in which is stored a plurality of pixmaps, each pixmap representing a respective character of the family of characters belonging to a font and each pixmap being accompanied by data representative of first and second dimensions of the pixmap, at least some of the pixmaps having first and second dimensions that differ from the first and / or second dimensions of other pixmaps in the same family of characters.

With the present invention as characters are represented by pixmaps in which the dimensions of the pixmaps may vary, the size of the pixmap data for each individual character can be minimised and the invention thus offers a more efficient data structure for storing the font data in terms of demands on memory space. Moreover, as the present invention reduces the number of pixels to be rendered for each character, this in turn reduces processor load and has the potential to increase rendering speed.

In a second aspect the present invention provides a font data software product in accordance with claim 15. The software product comprises a plurality of pixmaps, each pixmap representing a respective character of the family of characters belonging to a font and each pixmap being accompanied by data representative of first and second dimensions of the pixmap, at least some of the pixmaps having first and second dimensions that differ from the first and / or second dimensions of other pixmaps in the same family of characters.

In a third aspect, the present invention provides a method of structuring font data for storage in a memory in accordance with claim 26. The structure of the font data comprising a plurality of pixmaps, each pixmap representing a respective character of the family of characters belonging to the font and each pixmap being accompanied by data representative of first and second dimensions of the pixmap, at least some of the pixmaps having first and second dimensions that differ from the first and / or second dimensions of other pixmap in the same family of characters.

Ideally, each pixmap includes header data and the data representative of the first and second dimensions of the pixmap forms part of the header data and the first and second dimensions of the pixmaps are defined with respect to a height and a width.

In one embodiment the first and second dimensions of the pixmaps are separately represented in the header data by a height code and / or a width code. Moreover, either or both of the height code and the width code may be representative respectively, of the difference of the height of the image area and the width of the image area with respect to a predetermined height and a predetermined width.

In an alternative embodiment the first and second dimensions of the pixmaps are jointly represented in the header data by an image area code and wherein the storage device further includes a look-up table in which is stored a plurality of combinations of first and second dimensions and their respective image area codes.

In a fourth aspect the present invention provides an electronic device comprising a processor; a font data storage device as described above; a display; and a converter for accessing pixmaps relating to one or more characters from the font data storage device and communicating the image data for the one or more characters to the display.

The font data file of the present invention, in storing characters as pixmaps of variable size, is particularly well suited for use as an embedded font in systems having limited processing and/or memory resources, e.g. mobile phones, PDA's, MP3 players and set-top boxes.

Embodiments of the present invention will now be described by way of example with reference to the accompanying drawings, in which:
Figure 1 illustrates a conventional bitmap of the letter 'A' mapped onto a fixed rectangular array of 5x9 pixels;
Figure 2 illustrates a conventional bitmap of the letter 'a' mapped onto the same fixed rectangular array of 5x9 pixels;
Figure 3 illustrates a conventional bitmap of the letter'g' mapped onto the same fixed rectangular array of 5x9 pixels;
Figure 4 illustrates a bitmap of the letter 'a' mapped onto a rectangular array of 3x5 pixels, in accordance with the present invention;
Figure 5 illustrates the header information for two successive antialiased pixmaps of different sizes, in accordance with the present invention;
Figure 6 illustrates the header information for two successive antialiased pixmaps of different sizes using difference values, in accordance with the present invention; and
Figure 7 is a functional block diagram of an implementation of the font data management in accordance with the present invention suitable for implementation in an electronic device such as a set-top box.

Reference herein to font data is to be understood as reference to the family of characters including alphanumerics and associated punctuation having a common typeface and to non-western equivalents. Also, in the context of this document reference to a pixmap is intended as reference to image data in the form of an array of pixels in which each pixel is represented by one or more bits.

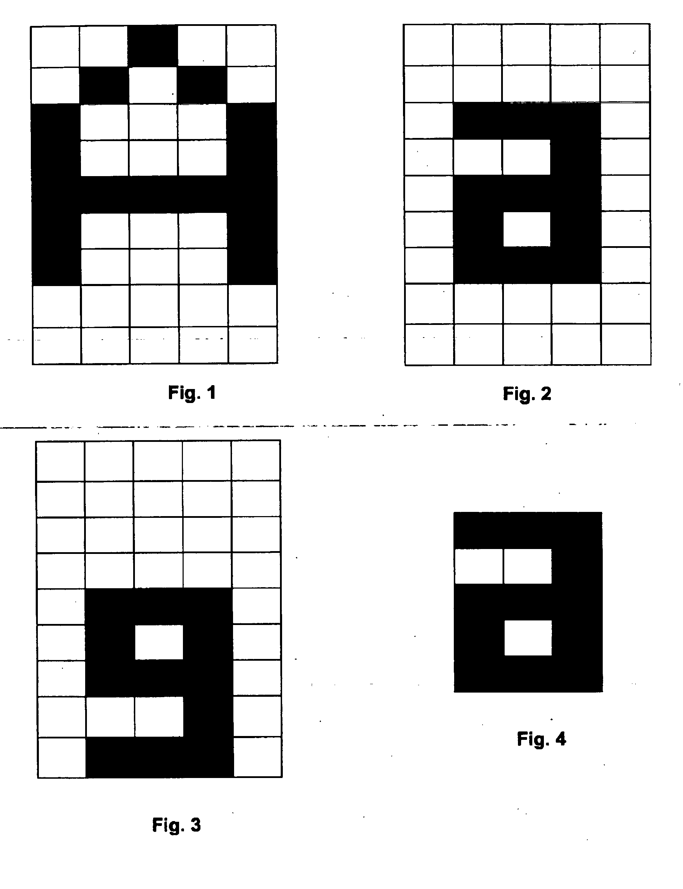

Figure 1 illustrates an uppercase 'A' mapped onto a conventional rectangular pixel array, or tile, of 5x9 pixels. Owing to the size of the uppercase character, as can be seen a large proportion of the pixels in the 5x9 tile are used to represent this character. However, in Figure 2 a lowercase 'a' mapped onto the same size of tile, 5x9 pixels, is illustrated. For this character several rows and columns of pixels are empty. Similarly, in Figure 3 a lowercase 'g' is illustrated and again several rows and columns of pixels are empty.

With the method of the present invention, on the other hand, characters of a particular typeface are mapped onto rectangular pixel arrays or tiles which have variable first and second dimensions, in this case height and width. Ideally, the first and second dimensions of each tile are chosen such that no empty row or column of pixels exists, although for certain characters it may be necessary to have one or more empty rows or columns of pixels. Thus, in accordance with the present invention the uppercase letter 'A' of Figure 1 would be mapped onto a tile of 5x7 pixels and the lowercase letter 'a' of Figure 2 is mapped onto a tile of only 3x5 pixels, as illustrated in Figure 4.

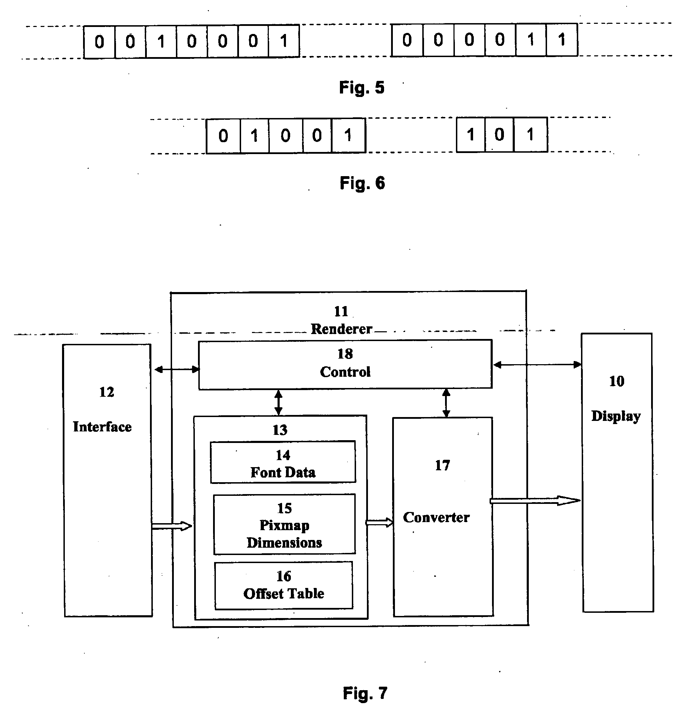

With the method of the present invention, antialiased pixmaps for each character are stored in a font data file along with respective header information. The data for each character may be flagged to indicate the position in the file of the next pixmap or the font data file may be organised so that an individual character can be accessed quickly with respect to a list of offsets with respect to the beginning of the data file. The header information for each pixmap includes data on either and preferably both the first and second dimensions, namely the height and the width, in terms of the number of pixels, of the pixmap. In one embodiment in the header information the total number of bits before and inclusive of a complement bit, for example "0,0,0,1" identifies the height of the pixmap and similarly the next total number of bits before and inclusive of a complement bit identifies the width. Thus, "0,0,0,0,1,0,0,1" (or "1,1,1,1,0,1,1,0") is one representation of the header information required for the pixmap illustrated in Figure 4 which has a height of 5 pixels and a width of 3 pixels. This method of identifying the size of each pixmap is efficient where the number of pixels for each pixmap is small. However, there are alternative methods of representing the image area of the pixmap in the header which offer further reductions in the number of bits. Indeed, in the case of a pixmap which is 1 pixel wide and 1 pixel high, the size information in the header for the pixmap may consist of a single bit. In Figure 5 the header information in the font data file for two sequential pixmaps is illustrated. The header information for the first pixmap indicates that the pixmap is 3 pixels in height and 4 pixels wide. The header information for the second pixmap indicates that the second pixmap is 5 pixels high and 1 pixel wide.

By reducing the size of each pixmap to the minimum number of pixels necessary to display the glyph and by adding header information to each pixmap which identifies its height and width, the memory space required for the font data file is reduced in comparison to conventional font data files which rely upon fixed width size bitmaps. The above example does not maximise the efficiency with which the header information is populated with size information. Ideally, the distribution of sizes of pixmaps may be analysed so that the most common sizes for the height and width of the pixmaps are allocated values using the smallest number of bits for example using Huffman coding.

One example of a way of reducing the number of bits required to identify the size of an individual pixmap is set out below. For many typefaces, the width and height distributions of the pixmaps will be biased towards a maximum, i.e. the mean width/height will be greater than half that of the maximum width/height. For example, if all characters are mapped onto pixel arrays having sizes no greater than 5x7 pixels, the average width and height of the pixmaps will generally be greater than 3 pixels. For the 5x9 bitmaps illustrated in Figures 1, 2 and 3, the average width and height is respectively 3.67 and 5.67. In general, therefore, the width and height of each pixmap may be more efficiently stored as difference values in comparison to known maximums.

Figure 6 illustrates the header information for two successive pixmaps where the height and width of each pixmap is identified as a difference value with respect to a predetermined maximum number of pixels. Thus, the total number of bits before and inclusive of a complement bit (counting from zero as a difference calculation is to be performed) indicates how much smaller than the maximum number of pixels is the height or width of the pixmap. The example of Figure 5 assumes a predetermined maximum height for each pixmap of 7 pixels and a predetermined maximum width for each pixmap of 5 pixels. Thus, the header information for the first pixmap in Figure 6 identifies a difference of 1 pixel from the maximum for the height of the pixmap and a difference of 2 pixels from the maximum for the width. Accordingly, the first pixmap has a height of 6 pixels (7 minus 1) and a width of 3 pixels (5 minus 2). For the second pixmap, There are no empty bits preceding the first "1" in the header information which indicates a difference of zero for the height of the pixmap and "0,1" indicating a difference of 1 for the width of the pixmap. The second pixmap therefore has a height of 7 pixels and a width of 4 pixels. Thus it can be seen that by using difference values, as opposed to direct counts of bits in the header information, to indicate the size of each pixmap the number of bits in the header information may be reduced.

It will, of course, be apparent that where difference values are employed, the predetermined maximum height and width for all pixmaps may be stored separately in the bitmap font data file or may be stored elsewhere for access by the processor whenever the bitmap font data file is accessed. For example, whilst only one typeface of a particular size (e.g. 10pt Times Roman) may be stored having a single maximum height and maximum width, three separate font data structures would be required to represent normal, bold and italic characters. As the system uses the same fixed maximum height and maximum width for each font data file, there is no need to store these values individually in the font data files.

With the method thus far described, the pixmaps (or character tiles) have variable widths and heights (with respect to actual or difference values) that are recorded in the header information to each pixmap. In an alternative embodiment of the present invention, the pixmaps are assigned selected widths and heights from a range of predetermined widths and heights. For the sake of simplicity, reference will now be made only to the use of predetermined heights. However, the same method may equally be used to identify the widths of the pixmaps.

In the simplest implementation, all pixmaps are assigned one of a plurality of predetermined first dimensions e.g. heights: H1 or H2 etc. For example, the uppercase character of Figure 1 may be assigned height H1 (7 pixels) and the lowercase character of Figure 2 assigned height H2 (5 pixels). The header information for an individual pixmap would then require a single bit to indicate whether that pixmap has height H1 or H2. That is to say, the first size bit in the header information would be set to "0" if the height of the pixmap is H1, or set to "1" if the height is H2 or vice versa. If the second dimension, in this case the width, of the pixmap is also limited to a selection of two alternative sizes then the size of an individual pixmap can be fully identified using only two bits. In this alternative embodiment, the height of each pixmap is recorded in the header information as a fixed number of bits, with the bits of each pixmap identifying a selection of one height and one width from a plurality of selectable predetermined sizes. In storing the size of each pixmap in this manner, the number of bits required to identify the size of the pixmap in the header information is further reduced where the number of selectable heights and widths is small. However, as each of the pixmaps is limited to predetermined heights /widths, the amount of memory required to store all of the pixmaps may greater than for the examples given earlier as certain pixmaps may include one or more empty pixel rows where the actual height and / or width of the character is less than the predetermined selectable sizes. For example, if the predetermined selectable heights are 5 and 7 pixels, a character having a height of only 3 pixels will have in the pixmap two empty pixel rows.

Here too, the predetermined selectable heights and widths of the pixmaps may be stored with the font data file or may be stored elsewhere in the system in, for example a look-up table. A similar system may be employed but with a single code jointly representing both the height and the width of the image area of the pixmap.

The header information for each pixmap preferably also records an x,y offset (the position of the character relative to an adjacent character). Again, for simplicity, reference will be made only to the offset of pixmaps in the vertical (y) direction. Nevertheless, the x offset (horizontal direction) may be recorded in a similar manner and may alternatively or additionally involve the spacing between pairs of characters being kerned so that the spacing varies for different pairs of characters.

As mentioned previously, conventional fixed size bitmaps were required to accommodate the lowest descender (letters g, y, j, p and q) and the highest ascenders (letters l, t, f, h, k and b) as well as the highest excursions (e.g. Á and Ü) and all other letters were arranged within the space of the fixed bitmap size so as to be appropriately aligned. Thus letters such as the letter 'a' were centrally positioned within the character tile with empty rows of pixels both above and below the glyph. In this way the relative alignment of individual characters was embedded in the individual fixed size bitmaps.

By adopting variable sized pixmaps the relative positioning of an individual character is lost from the content of the pixmap and instead is preferably recorded in the header information to each pixmap. Thus, in addition to the height and width of the pixmap, the header information may further include vertical and horizontal offset values with respect to respective reference lines. In the vertical direction the reference line may be the common base line for all letters having no descender with the vertical offset identifying the number of pixels below the reference line the base of a character should be positioned. Thus, the letter 'g' may have a vertical offset of 2 whereas all letters having no descender will have a zero vertical offset. Of course, the reference line may, in the alternative, identify the lowest position of the base of any individual character in which case letters having a descender such as the letter 'g' would have a zero offset and all letters having no descender would have an offset of, for example, 2 pixels above the reference line.

The offset values may be recorded in the header information as actual values or may be stored as a selection from a plurality of predetermined selectable offset positions. In the latter case, the vertical offset position of each pixmap may be recorded in the header information as one of two predetermined selectable positions: P1 and P2. For example, all characters not having a descender are assigned position P1, whilst characters having a descender are assigned position P2. Pixmaps having an offset position P1 are then displayed 2 pixels higher than pixmaps having an offset position P2. This enables the offset position to be identified in the header by means of a single bit of information. Alternative rules for identifying offset values in the header information using a minimum number of bits may, of course, be employed.

In a similar manner to the predetermined selectable heights and widths, the predetermined offset positions (P1 and P2) or their difference value (e.g. P1-P2) may be stored in the font data file or elsewhere in the system.

In Figure 7 an implementation of the font data management described herein suitable for use in a set-top box or other limited resources electronic device is illustrated schematically. The display 10 of an electronic device such as a set-top box receives the data it is to display from a renderer 11. In turn, the renderer 11 is instructed to build an image to be displayed via an input data display interface 12. In the case of a set-top box, the input data display interface 12 is adapted to communicate instructions from a local processor (not illustrated) and / or from a satellite or cable receiver (not illustrated) regarding the image to be displayed.

In response to instructions received via the input display data interface 12, the renderer 11 accesses from the font data store 13 the characters necessary for the required image display. In Figure 7 the pixmaps are stored separately in a memory 14 from a first look-up table 15 for pixmap sizes and a second look-up table 16 for offset data. Hence, in this example the header information for each pixmap stored in the font data store includes codes representative of the dimensions of the pixmap and the offset to be applied. These codes can then be used to locate in the tables 15, 16 the actual pixmap dimensions and offset for each pixmap.

The image data is then converted by a converter 17 into a form suitable for output to the display 10. Hence, the converter 17 interprets the pixmap dimensions and the offset for each pixmap to prepare a span table, for example, which represents the image of all of the characters to be displayed in terms of a succession of lines. This information is then communicated by the renderer 11 to the display 10 either line by line as it is generated by the converter or only after the entire image has been converted.

The overall operation of the renderer 11 is controlled by a control unit 18, the primary function of which is to sequence the operation of the various elements of the renderer. It will be appreciated that although the control unit 18 is illustrated as a distinct functional entity, in practice its functions are often embedded in other functional elements of the renderer 11.

By storing relative positional information in terms of offset values, with the present invention there is no longer any need for pixmaps to include empty pixel rows merely to attain correct alignment in relation to other characters and a further reduction in the amount of memory required for the font data file can be achieved.

With the method of recording and storing font data described above, bitmap font data may be stored in a manner which utilises less memory. In particular, bitmaps of individual characters are stored having a minimum of blank pixel rows or columns. Further savings in memory space are achieved through the manner of communicating size and offset position in the header information to each bitmap.

Of course, the present invention may also be used in conjunction with known methods of font compression. In particular, a font data file containing pixmaps of varying sizes may be subjected to run-length encoding to further compress the size of the file.

## Claims

1. A font data storage device comprising a memory (13) in which is stored a plurality of pixmaps (14), each pixmap representing a respective character of the family of characters belonging to a font and each pixmap being accompanied by data representative of first and second dimensions of the pixmap (15), at least some of the pixmaps having first and second dimensions that differ from the first and / or second dimensions of other pixmaps, wherein each pixmap includes header data and the data representative of the first and second dimensions of the pixmap forms part of the header data, wherein the first and second dimensions of the pixmaps are defined with respect to a height and a width of the image area of the pixmaps and are separately represented in header data by a height code and a width code **characterised in that** both or either of the height code and the width code are representative respectively of the difference between the height of the image area and a predetermined height value and/or the width of the image area and a predetermined width value wherein the predetermined height value and the predetermined width value are respectively the maximum height and width for any character belonging to the font family of characters.

2. A font data storage device as claimed in claim 1, wherein each pixmap has associated with it vertical offset data (16) being representative of a vertical offset position for the respective character, the vertical offset data comprising a single bit of information.

3. A font data storage device as claimed in either of claims 1 or 2, wherein each pixmap has associated with it horizontal offset data representative of a horizontal offset position for the respective character, the horizontal offset data including provision for the spacing between the respective character and an adjacent character in a character string.

4. A font data storage device as claimed in claims 2 and 3, wherein each pixmap includes header data with the vertical offset data and the horizontal offset data forming part of the header data.

5. A font data storage device as claimed in any one of the preceding claims, wherein each pixmap consists of a bitmap.

6. A font data storage device as claimed in any one of the preceding claims, wherein the plurality of pixmaps are compressed and stored in the memory as run lengths.

7. A font data storage device as claimed in any one of the preceding claims, wherein the memory (13) of the storage device is either a permanent or re-writable storage medium.

8. An electronic device comprising a processor, a font data storage device as claimed in any one of the preceding claims, a display (10), and a converter (17) for accessing pixmaps relating to one or more characters from the font data storage device (13) and communicating the image data for the one or more characters to the display.

9. An electronic device as claimed in claim 8, wherein the electronic device is a set-top box.

10. A font data software product comprising a plurality of pixmaps, each pixmap representing a respective character of the family of characters belonging to a font and each pixmap being accompanied by data representative of first and second dimensions of the pixmap, at least some of the pixmaps having first and second dimensions that differ from the first and / or second dimensions of other pixmaps wherein each pixmap includes header data and the data representative of the first and second dimensions of the pixmap forms part of the header data wherein the first and second dimensions of the pixmaps are defined with respect to a height and a width of the image area of the pixmaps and are separately represented in header data by a height code and a width code **characterised in that** both or either of the height code and the width code are representative respectively of the difference between the height of the image area and a predetermined height value and/or the width of the image area and a predetermined width value wherein the predetermined height value and the predetermined width value are respectively the maximum height and width for any character belonging to the font family of characters.

11. A font data software product as claimed in claim 10, wherein each pixmap has associated with it vertical offset data being representative of a vertical offset position for the respective character, the vertical offset data comprising a single bit of information.

12. A font data software product as claimed in either of claims 10 or 11, wherein each pixmap has associated with it horizontal offset data representative of a horizontal offset position for the respective character, the horizontal offset data including provision for the spacing between the respective character and an adjacent character in a character string.

13. A font data software product and claimed in claims 11 and 12, wherein each pixmap includes header data with the vertical offset data and the horizontal offset data forming part of the header data.

14. A font data software product as claimed in any one of claims 10 to 13, wherein each pixmap consists of a bitmap.

15. A font data software product as claimed in any one of claims 10 to 14, wherein the plurality of pixmaps are compressed and stored in the memory as run lengths.

16. A method of structuring font data for storage in a memory, the font data comprising a plurality of pixmaps, each pixmap representing a respective character of the family of characters belonging to the font and each pixmap being accompanied by data representative of first and second dimensions of the pixmap, at least some of the pixmaps having first and second dimensions that differ from the first and / or second dimensions of other pixmaps, wherein each pixmap includes header data and the data representative of the first and second dimensions of the pixmap forms part of the header data wherein the first and second dimensions of the pixmaps are defined with respect to a height and a width and are separately represented in the header data by a height code and a width code **characterised in that** both or either of the height code and the width code are representative respectively of the difference between the height of the image area and a predetermined height value and/or the width of the image area and a predetermined width value wherein the predetermined height value and the predetermined width value are respectively the maximum height and width for any character belonging to the font family of characters.

17. A method of structuring font data as claimed in claim 16, wherein each pixmap has associated with it vertical offset data being representative of a vertical offset position for the respective character, the vertical offset data comprising a single bit of information.

18. A method of structuring font data as claimed in either of claims 16 or 17, wherein each pixmap has associated with it horizontal offset data representative of a horizontal offset position for the respective character, the horizontal offset data including provision for the spacing between the respective character and an adjacent character in a character string.

19. A method of structuring font data as claimed in claims 17 and 18, wherein each pixmap includes header data and the vertical offset data and the horizontal offset data forms part of the header data.

20. A method of structuring font data as claimed in any one of claims 16 to 19, wherein each pixmap consists of a bitmap.

21. A method of structuring font data as claimed in any one of claims 16 to 20, wherein the header data further includes offset data for alignment of the character with other characters when displayed.

22. A method of structuring font data as claimed in any one of claims 16 to 21, wherein the plurality of pixmaps are compressed and stored in the memory as run lengths.

## Patentansprüche

1. Schriftartdaten-Speichereinrichtung, umfassend einen Speicher (13), in welchem eine Mehrzahl von Rastergrafiken (14) (Pixmaps) gespeichert sind, wobei jede Rastergrafik ein jeweiliges Zeichen aus der Familie von Zeichen repräsentiert, welche zu einer Schriftart gehören, und jede Rastergrafik von Daten (15) begleitet ist, die für erste und zweite Abmessungen der Rastergrafik repräsentativ sind, wobei mindestens einige der Rastergrafiken erste und zweite Abmessungen haben, die von den ersten und/oder zweiten Abmessungen anderer Rastergrafiken abweichen, wobei jede Rastergrafik Kopfdaten enthält und die Daten, die für die ersten und zweiten Abmessungen der Rastergrafik repräsentativ sind, Bestandteil der Kopfdaten sind, wobei die ersten und zweiten Abmessungen der Rastergrafiken im Hinblick auf eine Höhe und einen Breite des Bildbereichs der Rastergrafiken definiert sind und in den Kopfdaten getrennt durch einen Höhencode und einen Breitencode repräsentiert sind, **dadurch gekennzeichnet, dass** beides oder eines von dem Höhencode und dem Breitencode jeweils repräsentativ sind für die Abweichung zwischen der Höhe des Bildbereichs und einem vorgegebenen Höhenwert und/oder der Breite des Bildbereichs und einem vorgegebenen Breitenwert, wobei der vorgegebene Höhenwert und der vorgegebene Breitenwert jeweils die maximale Höhe und Breite für jedes Zeichen sind, die zu der Schriftartfamilie von Zeichen gehören.

2. Schriftartdaten-Speichereinrichtung gemäß Anspruch 1, wobei jeder Rastergrafik Vertikal-Versatzdaten (16) zugeordnet sind, die repräsentativ sind für eine Vertikal-Versatzposition für das jeweilige Zeichen, wobei die Vertikal-Versatzdaten ein einzelnes Informationsbit umfassen.

3. Schriftartdaten-Speichereinrichtung gemäß einem der Ansprüche 1 oder 2, wobei jeder Rastergrafik Horizontal-Versatzdaten zugeordnet sind, die repräsentativ sind für eine Horizontal-Versatzposition für das jeweilige Zeichen, wobei die Horizontal-Versatzdaten den Abstand zwischen dem jeweiligen Zeichen und einem benachbarten Zeichen in einer Zeichenfolge berücksichtigen.

4. Schriftartdaten-Speichereinrichtung gemäß den Ansprüchen 2 und 3, wobei jede Rastergrafik Kopfdaten enthält, wobei die Vertikal-Versatzdaten und die Horizontal-Versatzdaten Bestandteil der Kopfdaten sind.

5. Schriftartdaten-Speichereinrichtung gemäß einem der vorherigen Ansprüche, wobei jede Rastergrafik aus einer Bitmap besteht.

6. Schriftartdaten-Speichereinrichtung gemäß einem der vorherigen Ansprüche, wobei die Mehrzahl von Rastergrafiken komprimiert und im Speicher als Lauflängen gespeichert sind.

7. Schriftartdaten-Speichereinrichtung gemäß einem der vorherigen Ansprüche, wobei es sich bei dem Speicher (13) der Speichereinrichtung entweder um einen permanentes oder um ein wiederbeschreibbares Speichermedium handelt.

8. Elektronisches Gerät, umfassend einen Prozessor, eine Schriftartdaten-Speichereinrichtung gemäß einem der vorherigen Ansprüche, eine Anzeige (10) und einen Konverter (17) zum Zugreifen auf Rastergrafiken, die zu einem oder mehreren Zeichen gehören, aus der Schriftartdaten-Speichereinrichtung (13) und zum Kommunizieren der Bilddaten für das eine oder die mehreren Zeichen zu der Anzeige.

9. Elektronisches Gerät gemäß Anspruch 8, wobei es sich bei dem elektronischen Gerät um eine Set-Top-Box handelt.

10. Schriftartdaten-Softwareprodukt, umfassend eine Mehrzahl von Rastergrafiken (Pixmaps), wobei jede Rastergrafik ein jeweiliges Zeichen aus der Familie von Zeichen repräsentiert, welche zu einer Schriftart gehören, und jede Rastergrafik von Daten begleitet ist, die für erste und zweite Abmessungen der Rastergrafik repräsentativ sind, wobei mindestens einige der Rastergrafiken erste und zweite Abmessungen haben, die von den ersten und/oder zweiten Abmessungen anderer Rastergrafiken abweichen, wobei jede Rastergrafik Kopfdaten enthält und die Daten, die für die ersten und zweiten Abmessungen der Rastergrafik repräsentativ sind, Bestandteil der Kopfdaten sind, wobei die ersten und zweiten Abmessungen der Rastergrafiken im Hinblick auf eine Höhe und einen Breite des Bildbereichs der Rastergrafiken definiert sind und in den Kopfdaten getrennt durch einen Höhencode und einen Breitencode repräsentiert sind, **dadurch gekennzeichnet, dass** beides oder eines von dem Höhencode und dem Breitencode jeweils repräsentativ sind für die Abweichung zwischen der Höhe des Bildbereichs und einem vorgegebenen Höhenwert und/oder der Breite des Bildbereichs und einem vorgegebenen Breitenwert, wobei der vorgegebene Höhenwert und der vorgegebene Breitenwert jeweils die maximale Höhe und Breite für jedes Zeichen sind, die zu der Schriftartfamilie von Zeichen gehören.

11. Schriftartdaten-Softwareprodukt gemäß Anspruch 10, wobei jeder Rastergrafik Vertikal-Versatzdaten zugeordnet sind, die repräsentativ sind für eine Vertikal-Versatzposition für das jeweilige Zeichen, wobei die Vertikal-Versatzdaten ein einzelnes Informationsbit umfassen.

12. Schriftartdaten-Softwareprodukt gemäß einem der Ansprüche 10 oder 11, wobei jeder Rastergrafik Horizontal-Versatzdaten zugeordnet sind, die repräsentativ sind für eine Horizontal-Versatzposition für das jeweilige Zeichen, wobei die Horizontal-Versatzdaten den Abstand zwischen dem jeweiligen Zeichen und einem benachbarten Zeichen in einer Zeichenfolge berücksichtigen.

13. Schriftartdaten-Softwareprodukt gemäß den Ansprüchen 11 und 12, wobei jede Rastergrafik Kopfdaten enthält, wobei die Vertikal-Versatzdaten und die Horizontal-Versatzdaten Bestandteil der Kopfdaten sind.

14. Schriftartdaten-Softwareprodukt gemäß einem der Ansprüche 10 bis 13, wobei jede Rastergrafik aus einer Bitmap besteht.

15. Schriftartdaten-Softwareprodukt gemäß einem der Ansprüche 10 bis 14, wobei die Mehrzahl von Rastergrafiken komprimiert und im Speicher als Lauflängen gespeichert sind.

16. Verfahren zur Strukturierung von Schriftartdaten zur Speicherung in einem Speicher, wobei die Schriftartdaten eine Mehrzahl von Rastergrafiken (Pixmaps) umfassen, wobei jede Rastergrafik ein jeweiliges Zeichen aus der Familie von Zeichen repräsentiert, welche zu einer Schriftart gehören, und jede Rastergrafik von Daten begleitet ist, die für erste und zweite Abmessungen der Rastergrafik repräsentativ sind, wobei mindestens einige der Rastergrafiken erste und zweite Abmessungen haben, die von den ersten und/oder zweiten Abmessungen anderer Rastergrafiken abweichen, wobei jede Rastergrafik Kopfdaten enthält und die Daten, die für die ersten und zweiten Abmessungen der Rastergrafik repräsentativ sind, Bestandteil der Kopfdaten sind, wobei die ersten und zweiten Abmessungen der Rastergrafiken im Hinblick auf eine Höhe und einen Breite definiert sind und in den Kopfdaten getrennt durch einen Höhencode und einen Breitencode repräsentiert sind, **dadurch gekennzeichnet, dass** beides oder eines von dem Höhencode und dem Breitencode jeweils repräsentativ sind für die Abweichung zwischen der Höhe des Bildbereichs und einem vorgegebenen Höhenwert und/oder der Breite des Bildbereichs und einem vorgegebenen Breitenwert, wobei der vorgegebene Höhenwert und der vorgegebene Breitenwert jeweils die maximale Höhe und Breite für jedes Zeichen sind, die zu der Schriftartfamilie von Zeichen gehören.

17. Verfahren zur Strukturierung von Schriftartdaten gemäß Anspruch 16, wobei jeder Rastergrafik Vertikal-Versatzdaten zugeordnet sind, die repräsentativ sind für eine Vertikal-Versatzposition für das jeweilige Zeichen, wobei die Vertikal-Versatzdaten ein einzelnes Informationsbit umfassen.

18. Verfahren zur Strukturierung von Schriftartdaten gemäß einem der Ansprüche 16 oder 17, wobei jeder Rastergrafik Horizontal-Versatzdaten zugeordnet sind, die repräsentativ sind für eine Horizontal-Versatzposition für das jeweilige Zeichen, wobei die Horizontal-Versatzdaten den Abstand zwischen dem jeweiligen Zeichen und einem benachbarten Zeichen in einer Zeichenfolge berücksichtigen.

19. Verfahren zur Strukturierung von Schriftartdaten gemäß den Ansprüchen 17 und 18, wobei jede Rastergrafik Kopfdaten enthält und die Vertikal-Versatzdaten und die Horizontal-Versatzdaten Bestandteil der Kopfdaten sind.

20. Verfahren zur Strukturierung von Schriftartdaten gemäß einem der Ansprüche 16 bis 19, wobei jede Rastergrafik aus einer Bitmap besteht.

21. Verfahren zur Strukturierung von Schriftartdaten gemäß einem der Ansprüche 16 bis 20, wobei die Kopfdaten des Weiteren Versatzdaten für die Ausrichtung des Zeichens an anderen Zeichen bei der Anzeige enthalten.

22. Verfahren zur Strukturierung von Schriftartdaten gemäß einem der Ansprüche 16 bis 21, wobei die Mehrzahl von Rastergrafiken komprimiert und im Speicher als Lauflängen gespeichert sind.

## Revendications

1. Un dispositif de stockage de données de police comprenant une mémoire (13) dans laquelle est stockée une pluralité de tables de pixels (14), chaque table de pixels représentant un caractère respectif de la famille de caractères appartenant à une police et chaque table de pixels étant accompagnée de données représentatives de première et deuxième dimensions de la table de pixels (15), certaines au moins des tables de pixels ayant des première et deuxième dimensions qui diffèrent des première et/ou deuxième dimensions des autres tables de pixels, dans lequel chaque table de pixels inclut des données d'en-tête et les données représentatives des première et deuxième dimensions de la table de pixels font partie des données d'en-tête, dans lequel les première et deuxième dimensions des tables de pixels sont définies par rapport à une hauteur et une largeur de la zone d'image des tables de pixels et sont représentées séparément dans les données d'en-tête par un code de hauteur et un code de largeur **caractérisés en ce que** l'un ou l'autre ou les deux parmi le code de hauteur et le code de largeur sont représentatifs respectivement de la différence entre la hauteur de la zone d'image et une valeur de hauteur prédéterminée et/ou la largeur de la zone d'image et une valeur de largeur prédéterminée, dans lequel la valeur de hauteur prédéterminée et la valeur de largeur prédéterminée sont respectivement la hauteur et la largeur maximales pour n'importe quel caractère appartenant à la famille de caractères de la police.

2. Un dispositif de stockage de données de police tel que revendiqué dans la revendication 1, dans lequel sont associées à chaque table de pixels des données de décalage vertical (16) étant représentatives d'une position de décalage vertical pour le caractère respectif, les données de décalage vertical comprenant un bit d'information unique.

3. Un dispositif de stockage de données de police tel que revendiqué dans n'importe lesquelles des revendications 1 ou 2, dans lequel sont associées à chaque table de pixels des données de décalage horizontal représentatives d'une position de décalage horizontal pour le caractère respectif, les données de décalage horizontal prévoyant notamment l'espacement entre le caractère respectif et un caractère adjacent dans une chaîne de caractères.

4. Un dispositif de stockage de données de police tel que revendiqué dans les revendications 2 et 3, dans lequel chaque table de pixels inclut des données d'en-tête, les données de décalage vertical et les données de décalage horizontal faisant partie des données d'en-tête.

5. Un dispositif de stockage de données de police tel que revendiqué dans n'importe laquelle des revendications précédentes, dans lequel chaque table de pixels consiste en une table de bits.

6. Un dispositif de stockage de données de police tel que revendiqué dans n'importe laquelle des revendications précédentes, dans lequel la pluralité des tables de pixels sont compressées et stockées dans la mémoire en longueurs de plage.

7. Un dispositif de stockage de données de police tel que revendiqué dans n'importe laquelle des revendications précédentes, dans lequel la mémoire (13) du dispositif de stockage est un support de stockage permanent ou réinscriptible.

8. Un dispositif électronique comprenant un processeur, un dispositif de stockage de données de police tel que revendiqué dans n'importe laquelle des revendications précédentes, un affichage (10), et un convertisseur (17) pour accéder aux tables de pixels relatives à un ou plusieurs caractères du dispositif de stockage de données de police (13) et communiquer les données d'image pour le ou les caractères à l'affichage.

9. Un dispositif électronique tel que revendiqué dans la revendication 8, dans lequel le dispositif électronique est un boîtier adaptateur.

10. Un produit logiciel de données de police comprenant une pluralité de tables de pixels, chaque table de pixels représentant un caractère respectif de la famille de caractères appartenant à une police et chaque table de pixels étant accompagnée de données représentatives de première et deuxième dimensions de la table de pixels, certaines au moins des tables de pixels ayant des première et deuxième dimensions qui diffèrent des première et/ou deuxième dimensions des autres tables de pixels, dans lequel chaque table de pixels inclut des données d'en-tête et les données représentatives des première et deuxième dimensions de la table de pixels font partie des données d'en-tête, dans lequel les première et deuxième dimensions des tables de pixels sont définies par rapport à une hauteur et une largeur de la zone d'image des tables de pixels et sont représentées séparément dans les données d'en-tête par un code de hauteur et un code de largeur **caractérisés en ce que** l'un ou l'autre ou les deux parmi le code de hauteur et le code de largeur sont représentatifs respectivement de la différence entre la hauteur de la zone d'image et une valeur de hauteur prédéterminée et/ou la largeur de la zone d'image et une valeur de largeur prédéterminée, dans lequel la valeur de hauteur prédéterminée et la valeur de largeur prédéterminée sont respectivement la hauteur et la largeur maximales pour n'importe quel caractère appartenant à la famille de caractères de la police.

11. Un produit logiciel de données de police tel que revendiqué dans la revendication 10, dans lequel sont associées à chaque table de pixels des données de décalage vertical étant représentatives d'une position de décalage vertical pour le caractère respectif, les données de décalage vertical comprenant un bit d'information unique.

12. Un produit logiciel de données de police tel que revendiqué dans n'importe lesquelles des revendications 10 ou 1 l, dans lequel sont associées à chaque table de pixels des données de décalage horizontal représentatives d'une position de décalage horizontal pour le caractère respectif, les données de décalage horizontal prévoyant notamment l'espacement entre le caractère respectif et un caractère adjacent dans une chaîne de caractères.

13. Un produit logiciel de données de police tel que revendiqué dans les revendications 11 et 12, dans lequel chaque table de pixels inclut des données d'en-tête, les données de décalage vertical et les données de décalage horizontal faisant partie des données d'en-tête.

14. Un produit logiciel de données de police tel que revendiqué dans n'importe laquelle des revendications 10 à 13, dans lequel chaque table de pixels consiste en une table de bits.

15. Un produit logiciel de données de police tel que revendiqué dans n'importe laquelle des revendications 10 à 14, dans lequel la pluralité des tables de pixels sont compressées et stockées dans la mémoire en longueurs de plage.

16. Un procédé pour structurer des données de police pour un stockage dans une mémoire, les données de police comprenant une pluralité de tables de pixels, chaque table de pixels représentant un caractère respectif de la famille de caractères appartenant à la police et chaque table de pixels étant accompagnée de données représentatives de première et deuxième dimensions de la table de pixels, certaines au moins des tables de pixels ayant des première et deuxième dimensions qui diffèrent des première et/ou deuxième dimensions des autres tables de pixels, dans lequel chaque table de pixels inclut des données d'en-tête et les données représentatives des première et deuxième dimensions de la table de pixels font partie des données d'en-tête, dans lequel les première et deuxième dimensions des tables de pixels sont définies par rapport à une hauteur et une largeur et sont représentées séparément dans les données d'en-tête par un code de hauteur et un code de largeur **caractérisés en ce que** l'un ou l'autre ou les deux parmi le code de hauteur et le code de largeur sont représentatifs respectivement de la différence entre la hauteur de la zone d'image et une valeur de hauteur prédéterminée et/ou la largeur de la zone d'image et une valeur de largeur prédéterminée, dans lequel la valeur de hauteur prédéterminée et la valeur de largeur prédéterminée sont respectivement la hauteur et la largeur maximales pour n'importe quel caractère appartenant à la famille de caractères de la police.

17. Un procédé pour structurer des données de police tel que revendiqué dans la revendication 16, dans lequel sont associées à chaque table de pixels des données de décalage vertical étant représentatives d'une position de décalage vertical pour le caractère respectif, les données de décalage vertical comprenant un bit d'information unique.

18. Un procédé pour structurer des données de police tel que revendiqué dans n'importe lesquelles des revendications 16 ou 17, dans lequel sont associées à chaque table de pixels des données de décalage horizontal représentatives d'une position de décalage horizontal pour le caractère respectif, les données de décalage horizontal prévoyant notamment l'espacement entre le caractère respectif et un caractère adjacent dans une chaîne de caractères.

19. Un procédé pour structurer des données de police tel que revendiqué dans les revendications 17 et 18, dans lequel chaque table de pixels inclut des données d'en-tête et les données de décalage vertical et les données de décalage horizontal font partie des données d'en-tête.

20. Un procédé pour structurer des données de police tel que revendiqué dans n'importe laquelle des revendications 16 à 19, dans lequel chaque table de pixels consiste en une table de bits.

21. Un procédé pour structurer des données de police tel que revendiqué dans n'importe laquelle des revendications 16 à 20, dans lequel les données d'en-tête comprennent en outre des données de décalage pour l'alignement du caractère avec les autres caractères quand ils sont affichés.

22. Un procédé pour structurer des données de police tel que revendiqué dans n'importe laquelle des revendications 16 à 21, dans lequel la pluralité des tables de pixels sont compressées et stockées dans la mémoire en longueurs de plage.
